(19) Europäisches Patentamt
European Patent Office
Office européen des brevets

(11) **EP 2 209 355 A1**

(12) **EUROPEAN PATENT APPLICATION**

(43) Date of publication:
**21.07.2010 Bulletin 2010/29**

(51) Int Cl.:
**H05K 1/02** *(2006.01)*  **H05K 3/22** *(2006.01)*
**H05K 3/34** *(2006.01)*

(21) Application number: **09009936.7**

(22) Date of filing: **31.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **15.01.2009 JP 2009006189**

(71) Applicant: **Mitsubishi Electric Corporation Tokyo 100-8310 (JP)**

(72) Inventor: **Kai, Akihiro Tokyo 102-0073 (JP)**

(74) Representative: **Pfenning, Meinig & Partner GbR Patent- und Rechtsanwälte Theresienhöhe 13 80339 München (DE)**

(54) **Electronic control device**

(57) In an electronic control device related to the present invention, a current circuit is formed on a printed circuit board 1, and an electric component with lead is soldered to the printed circuit board by a flow soldering method, the electronic control device includes: a copper foil flat pattern 28 forming a soldering surface current pattern at a soldering surface side which is flowed through by current of the current circuit at the soldering surface side of the printed circuit board and exposing copper foil; a through hole 29 formed on the copper foil flat pattern 28; and a jumper lead wire 30 to be mounted on the through hole 29 from the soldering surface side and soldered by the flow soldering method.

Fig. 4

**Description**

BACKGROUND OF THE INVENTION

FIELD OF THE INVENTION

The present invention relates to an electronic control device, to which treatment is applied for improving radiation performance and increasing a current allowable value of a printed circuit board pattern part which is flowed through by large current.

DISCUSSION OF THE BACKGROUND

In a conventional electronic control device, a jumper conductor made of conductor plate is soldered by reflow soldering to a copper foil flat pattern which requires to increase current carrying capacity (Patent Document 1, for example).

LIST OF REFERENCES

[Patent Document 1] JP2008-16582

The conventional electronic control device uses a specific jumper conductor to be soldered to the copper foil flat pattern which requires to increase the current carrying capacity, thereby causing a problem that a cost of the product is high, etc.

Further, the conventional electronic control device uses the specific jumper conductor, thereby causing a problem that it is impossible to be applied flexibly to change of design, etc. of the printed circuit board.

Generally, in the reflow soldering method, cream solder (solder paste) of around $0.15\mu m$ thickness is coated on the printed circuit board and then components are mounted on it. Further, in the flow soldering method, a printed circuit board on which a lead component (electronic component with lead terminal) is mounted is immersed in a soldering tank which is filled with molten solder, and thereby the soldering amount or the soldering volume can be made larger than the reflow soldering method. However, in the conventional electronic control device, since the jumper conductor is soldered by the reflow soldering method, less soldering amount or less soldering volume is obtained than the case of using the flow soldering method, and heat radiation of the printed board pattern cannot be done sufficiently. This causes a problem that the safety and reliability of the printed circuit board is degraded.

The present invention is made to solve the above problems and aims to provide an electronic control device which uses a general-purpose, inexpensive jumper lead wire without using a specific jumper conductor, thereby increasing the current carrying capacity of the printed circuit board, as well improving the radiation performance and increasing the current allowable value of the printed board pattern part which is flowed through by large current.

SUMMARY OF THE INVENTION

In an electronic control device related to the present invention, a current circuit is formed on a printed circuit board, and an electric component with lead is soldered to the printed circuit board by a flow soldering method, the electronic control device includes: a copper foil flat pattern forming a soldering surface current pattern at a soldering surface side which is flowed through by current of the current circuit at the soldering surface side of the printed circuit board and exposing copper foil; a through hole formed on the copper foil flat pattern; and a jumper lead wire to be mounted on the through hole from the soldering surface side and soldered by the flow soldering method.

BRIEF DESCRIPTION OF THE DRAWINGS

A complete appreciation of the present invention and many of the attendant advantages thereof will be readily obtained as the same becomes better understood by reference to the following detailed description when considered in connection with the accompanying drawings, wherein:

Fig. 1 shows the first embodiment, and is a control circuit block diagram showing an electronic control device 100 of an outdoor unit of an air conditioner;
Fig. 2 shows the first embodiment, and is a general pattern diagram of a noise-filtering circuit 8 of the electronic control device 100 of the outdoor unit of the air conditioner viewed from a lead component mounting side (component surface);
Fig. 3 shows the first embodiment, and is a general pattern diagram of the noise-filtering circuit 8 of the electronic control device 100 of the outdoor unit of the air conditioner viewed from a flow soldering side (soldering surface);
Fig. 4 shows the first embodiment, and shows a soldering surface large current pattern 27e of the flow soldering side (soldering surface) ((a) shows the soldering surface, (b) is a side view (before flow soldering), and (c) is a side view (after flow soldering);
Fig. 5 shows the first embodiment, and is an enlarged view of A of Fig. 4;
Fig. 6 shows the second embodiment, and shows soldering surface large current patterns 27d and 27g of the printed circuit board 1 ((a) shows the soldering surface, (b) is a side view (before flow soldering), and (c) is a side view (after flow soldering);
Fig. 7 shows the third embodiment, and shows the soldering surface of the printed circuit board 1;
Fig. 8 shows the fourth embodiment, and is an enlarged view of the soldering surface large current pattern 27e;

Fig. 9 shows the fourth embodiment, and shows the soldering surface of the printed circuit board 1;

Fig. 10 shows the fourth embodiment, and shows status in which a crack occurs in a copper foil flat pattern 28;

Fig. 11 is shown for comparison, and shows status in which a crack occurs when a jumper lead wires 30 are not arranged in a zigzag-like shape;

Fig. 12 shows the fifth embodiment, and shows the printed circuit board 1;

Fig. 13 shows the fifth embodiment, and shows the jumper lead wires 30 mounted on the copper foil flat pattern 28 of the soldering surface large current pattern 27e;

Fig. 14 shows the sixth embodiment, and shows side views of clinch shape of the jumper lead wire 30 of the printed circuit board 1 ((a-1) is a side view of general clinch shape of the jumper lead wire 30 (before flow soldering); (a-2) is a side view of general clinch shape of the jumper lead wire 30 (after flow soldering); (b-1) is a side view of clinch shape of the jumper lead wire 30 when the clinching tension is weakened (before flow soldering); and (b-2) is a side view of clinch shape of the jumper lead wire 30 when the clinching tension is weakened (after flow soldering)): and

Fig. 15 shows the seventh embodiment, and is a pattern diagram of a side of a surface (component surface) to which components with lead of the printed circuit board 1 of the electronic control device 100 are mounted.

DESCRIPTION OF THE PREFERRED EMBODIMENTS

Embodiment 1.

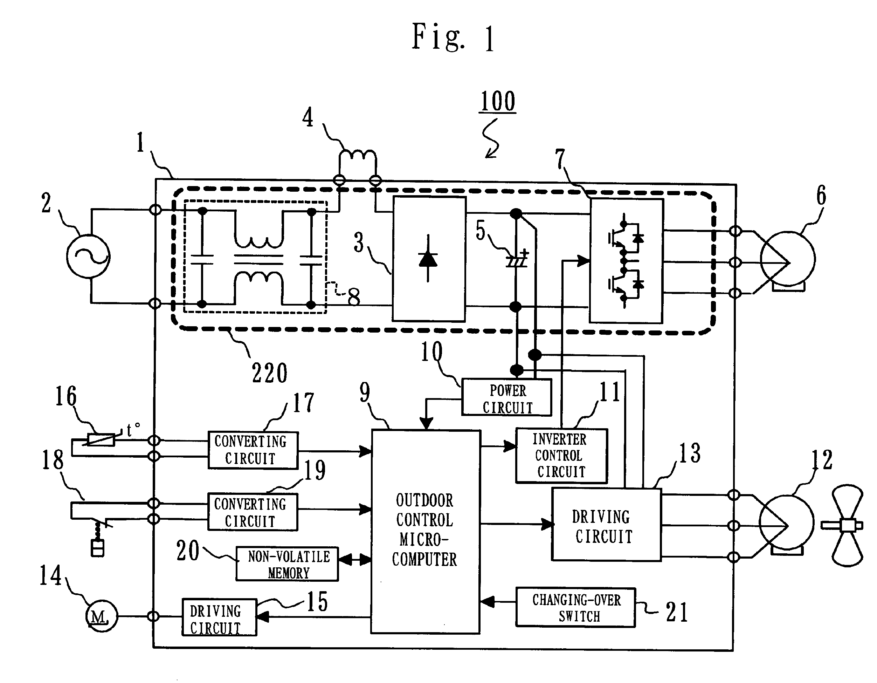

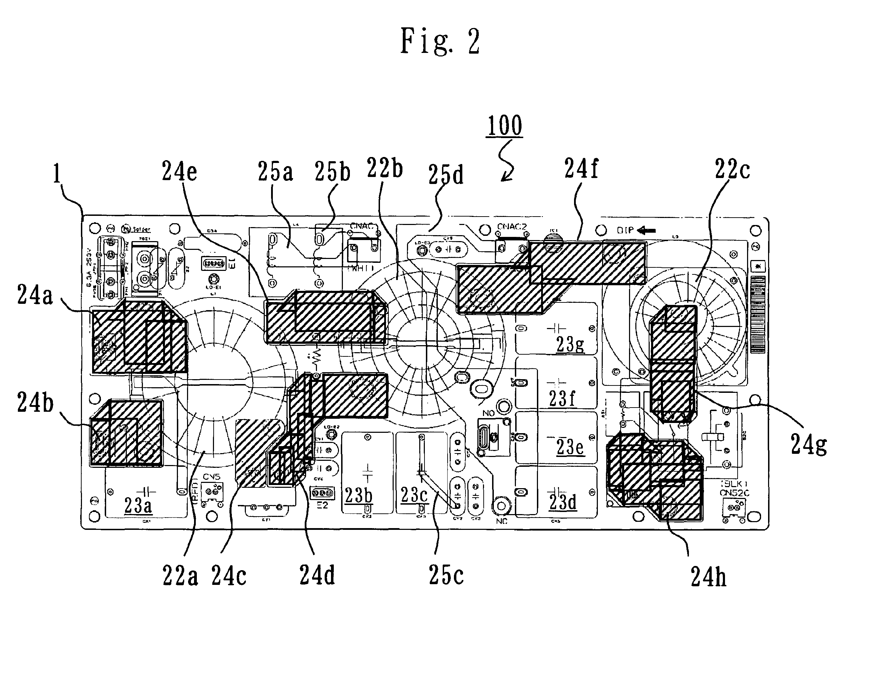

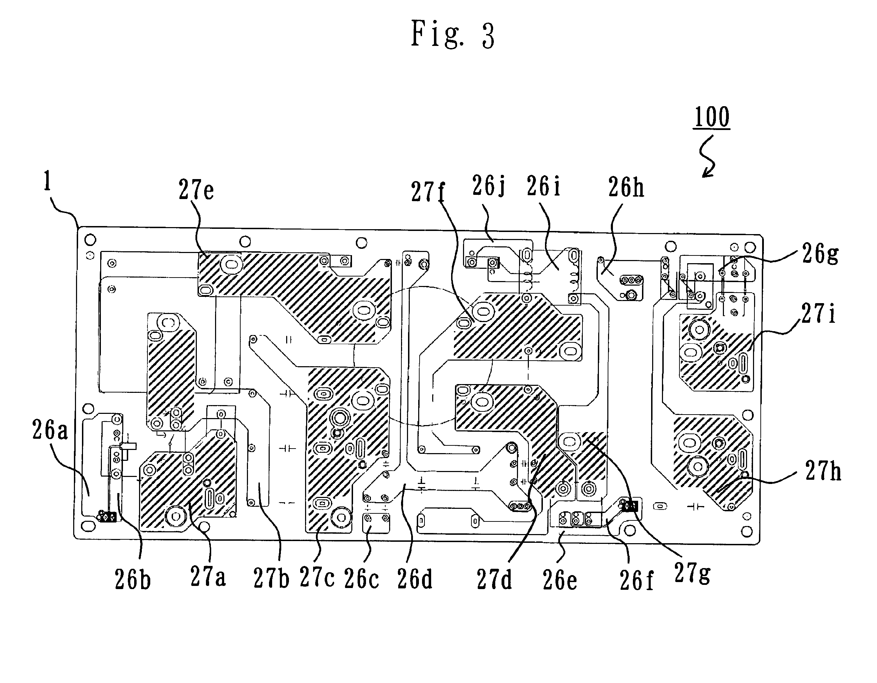

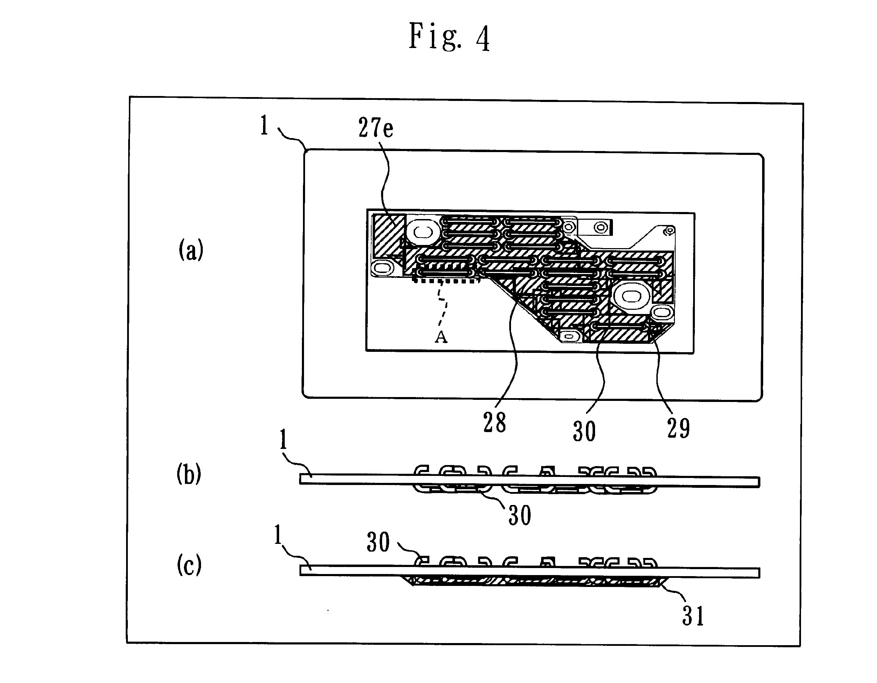

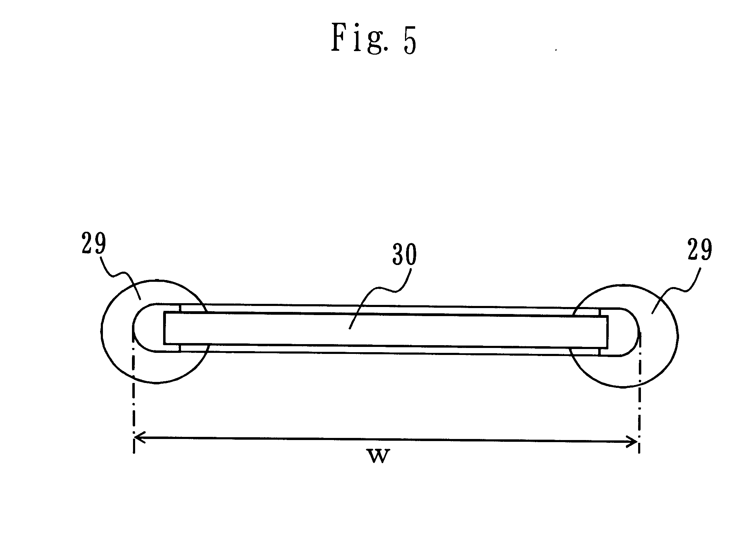

Figs. 1 through 5 show the first embodiment; Fig. 1 is a control circuit block diagram showing an electronic control device 100 of an outdoor unit of an air conditioner; Fig. 2 is a general pattern diagram of a noise-filtering circuit 8 of the electronic control device 100 of the outdoor unit of the air conditioner viewed from a lead component mounting side (component surface); Fig. 3 is a general pattern diagram of the noise-filtering circuit 8 of the electronic control device 100 of the air conditioner viewed from a flow soldering side (soldering surface); Fig. 4 shows a soldering surface large current pattern 27e of the flow soldering side (soldering surface) ((a) shows the soldering surface, (b) shows a side view (before flow soldering), and (c) also shows a side view (after flow soldering); and Fig. 5 is an enlarged view of an A part of Fig. 4.

In the present embodiment, the electronic control device 100 which conducts operation control of an outdoor unit of an air-conditioner will be explained as an example. The outdoor unit of the air conditioner is one of examples, and equipments for applying the electronic control device 100 is not limited to the outdoor unit of the air conditioner.

According to the present embodiment, a soldering surface large current pattern which requires large electric current to flow through is a copper foil flat pattern exposing copper foil. Then, a through hole is formed for inserting a jumper lead wire on the copper foil flat pattern. The jumper lead wire is inserted to the through hole, mounted on the copper foil flat pattern, and soldered by flow soldering.

The solder is adhered to the jumper lead wire, thereby increasing the volume of the conducting part to be greater than the volume of the jumper lead wire. Therefore, it is possible to improve radiation performance of the soldering surface large current pattern which is flowed through by large current and to increase the current allowable value.

First, the electronic control device 100 is defined. The electronic control device 100 means a current circuit formed on the printed circuit board 1, to which an electric component with lead terminal is soldered by the flow soldering method. In the present embodiment, within one printed circuit board 1, a small current circuit and a large current circuit are mounted mixedly.

As shown in Fig. 1, the electronic control device 100 formed by the printed circuit board 1, to which various electric components are mounted, conducts operation control of the outdoor unit of the air conditioner. AC commercial power source 2 (50 Hz or 60 Hz) is connected to the electronic control device 100.

A separate type air conditioner having an indoor unit and an outdoor unit will be discussed in the present embodiment as one of examples of the air conditioner.

A rectifying circuit 3 for converting AC of the AC commercial power source 2 to DC is connected to the AC commercial power source 2 via a power factor correction reactor 4.

A DC smoothing capacitor 5 is connected to the rectifying circuit 3. DC voltage generated by the DC smoothing capacitor 5 is converted to a desired AC voltage by the inverter circuit 7 for compressor, and the AC voltage is applied to the compressor 6 to operate the compressor 6.

The compressor 6 is, for example, a hermetic compressor, including a rotary compressor, a scroll compressor, a reciprocating compressor, etc.

The compressor 6 is provided with a compressing element for compressing refrigerant, and a motor element for driving the compressing element (both not illustrated).

As the motor element driving the compressing element, a brushless DC motor, an induction motor, etc. are used.

The noise-filtering circuit 8 suppresses noise generated by the inverter circuit 7 for compressor. Further, incoming noise from the AC commercial power source 2 is suppressed.

To the electronic control device 100 of the outdoor unit, an outdoor control micro-computer 9 which conducts control of various operation of the outdoor unit is mounted. The outdoor control micro-computer 9 is operated by micro-computer driving power source generated by the power circuit 10 from DC voltage generated by the DC smoothing capacitor 5.

Further, the outdoor control micro-computer 9 supplies an operation signal (PWM) of the compressor 6 to the inverter circuit 7 for compressor via an inverter control circuit 11. PWM means pulse width modulation.

In the outdoor unit of the air conditioner, an outdoor heat exchanger that forms a refrigerating cycle, not illustrated, is provided. An outdoor blower for blowing air to the outdoor heat exchanger includes a fan and a fan motor 12 for driving the fan.

The fan motor 12 is driven by a driving instruction transmitted via a driving circuit 13 from the outdoor control micro-computer 9.

The outdoor unit of the air conditioner includes an electronic expansion valve 14 as a depression device that forms the refrigerating cycle. The electronic expansion valve 14 is driven by the driving instruction transmitted from the outdoor control micro-computer 9 via the driving circuit 15.

Further, the outdoor unit of the air conditioner includes a refrigerant temperature detecting sensor 16 for detecting temperature of the refrigerant of the refrigerating cycle. Information of the refrigerant temperature detecting sensor 16 is imported to the outdoor control micro-computer 9 via a converting circuit 17.

Further, the outdoor unit of the air conditioner includes a pressure opening/closing switch 18. Information of the pressure opening/closing switch 18 is imported to the outdoor control micro-computer 9 via a converting circuit 19.

Further, a changing-over switch 21 for switching various driving operation of the outdoor unit of the air conditioner is provided to the electronic control device 100 of the outdoor unit. Contents of setting of the changing-over switch 21 is to be imported to the outdoor control micro-computer 9.

Further, a non-volatile memory 20 is provided to the electronic control device 100 to carry out writing/reading of various information by the outdoor control micro-computer 9.

A current circuit part of a region enclosed by a broken line of Fig. 1 is a large current circuit part 220 through which large current flows when the outdoor unit of the air conditioner is driven; sometimes current being equal to or greater than 20 A (ampere) flows. The current circuit part of Fig. 1 other than the large current circuit part is a small current circuit part through which small current flows, for example, smaller than 20 A (ampere). No reference sign is put to the small current circuit part.

Figs. 2 and 3 are examples showing a noise-filtering circuit 8 of the printed circuit board 1 of the electronic control device 100. Fig. 2 is a diagram of the noise-filtering circuit 8 viewed from a lead component mounting side (component surface).

The noise-filtering circuit 8 includes noise-filtering coils 22a through 22c and noise-filtering capacitors 23a through 23g, etc. for suppressing generated noise and incoming noise.

An electric component with lead terminal such as the noise-filtering coils 22a through 22c and noise-filtering capacitors 23a through 23g, etc. for suppressing generated noise and incoming noise is defined as an electric component with lead terminal (lead component).

A surface of the printed circuit board 1 to which the electric component with lead terminal (lead component) is mounted is defined as a component surface.

Lead component mounting side large current patterns 24a through 24h and lead component mounting side small current patterns 25a through 25d of the noise-filtering circuit 8 are patterns to which various components are connected.

In Fig. 2, shaded areas of the lead component mounting side large current patterns 24a through 24h are pattern parts through which large current flows.

Fig. 3 shows the noise-filtering circuit 8 viewed from a flow soldering side (soldering surface). The noise-filtering circuit 8 includes soldering surface current patterns for connecting various components; that is, soldering surface small current patterns 26a through 26j through which small current flows and soldering surface large current patterns 27a through 27i of the large current circuit part 220 through which large current flows.

In Fig. 3, the areas of the soldering surface large current patterns 27a through 27i shown by shading are pattern parts through which the large current for driving the compressor 6 of the air conditioner; in the present embodiment, the electric current of, for example, equal to or greater than 20 A (ampere) sometimes flows. Further, through the soldering surface small current patterns 26a through 26j, small current of less than 20 A flows.

Next, a main structure of the present embodiment will be explained. Fig. 4 shows the soldering surface large current pattern 27e, for example.

In Fig. 4, among the soldering surface current patterns, for example, the soldering surface large current pattern 27e, which requires large current of equal to or greater than 20 A to flow through, is a copper foil flat pattern 28 which exposes copper foil.

Then, a through hole 29 is provided on the copper foil flat pattern 28 for inserting a jumper lead wire 30 (also refer to Fig. 5). In the printed circuit board 1, the jumper lead wires 30 are mounted on the copper foil flat pattern 28 and soldered by flow soldering with solder 31 (flow soldering method).

The electronic control device 100 is structured as has been discussed, and thereby the solder 31 is adhered to the jumper lead wire 30 at flow soldering, and the volume of a conductor part is made larger than the volume of the jumper lead wire 30. Therefore, it is possible to improve the radiation performance and also to increase the current allowable value of the pattern which is flowed through by large current, for example, the soldering surface large current pattern 27e.

According to the present invention, the electronic control device is structured to form the soldering surface current pattern which is flowed through by electric current of the electric circuit at the soldering surface side to which the flow soldering is done in the printed circuit board, and to include a copper foil flat pattern which exposes copper foil, the through hole formed on the copper foil flat pattern, and the jumper lead wire which is soldered by the flow soldering method. Therefore, the present invention brings an effect to increase the current carrying capacity of the printed circuit board and improve the radiation performance of the printed board pattern part which is flowed through by large current, and increase the current allowable value without using a specific jumper conductor, but only using a general-purpose and inexpensive jumper lead wire.

Embodiment 2.

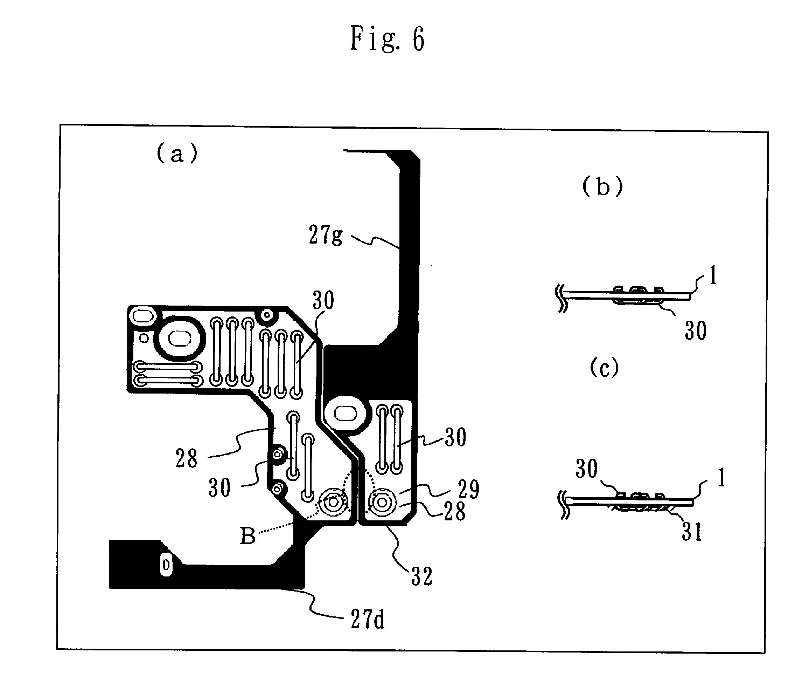

Fig. 6 shows the second embodiment, and illustrates soldering surface large current patterns 27d and 27g of the printed circuit board 1 ((a) shows the soldering surface, (b) shows a side view (before flow soldering), and (c) also shows the side view (after flow soldering)).

In Fig. 6, among the soldering surface current patterns, the soldering surface large current patterns 27d and 27g, which require large current to flow through, are copper foil flat patterns 28 which expose copper foil.

The soldering surface large current patterns 27d and 27g have through holes 29 on the respective copper foil flat patterns 28 for inserting the jumper lead wires 30.

In addition, after forming a resist part 32 having a certain width (a predetermined width) along an outer circumference of each copper foil flat pattern 28, the jumper lead wires 30 are mounted on the copper foil flat pattern 28 and soldered by flow soldering.

The resist parts 32 are applied to secure electric insulating properties between the copper foil flat patterns 28 of the soldering surface large current patterns 27d and 27g. Around a B part shown in (a) of Fig. 6, in particular, the copper foil flat patterns 28 of the soldering surface large current patterns 27d and 27g are located close to each other. Therefore, there is a possibility that the copper foil flat patterns 28 may be short-circuited because of the soldering. By forming the resist parts 32 having a certain width (a predetermined width) along the outer circumferences of the respective copper foil flat patterns 28, thereby suppressing the short-circuit by solder between the neighboring copper foil flat patterns 28 at flow soldering.

The printed circuit board 1 of the electronic control device 100 is structured as has been discussed, and thereby the solder 31 is adhered to the jumper lead wire 30 at flow soldering, which makes the volume of a conductor part larger than the volume of the jumper lead wire 30. It is possible to improve the radiation performance and also increase the current allowable value of, for example, the soldering surface large current patterns 27d and 27g.

Further, by forming the resist part 32 having a certain width along the outer circumference of the copper foil flat pattern 28, the short-circuit by solder between the neighboring copper foil flat patterns 28 can be prevented at flow soldering.

Embodiment 3.

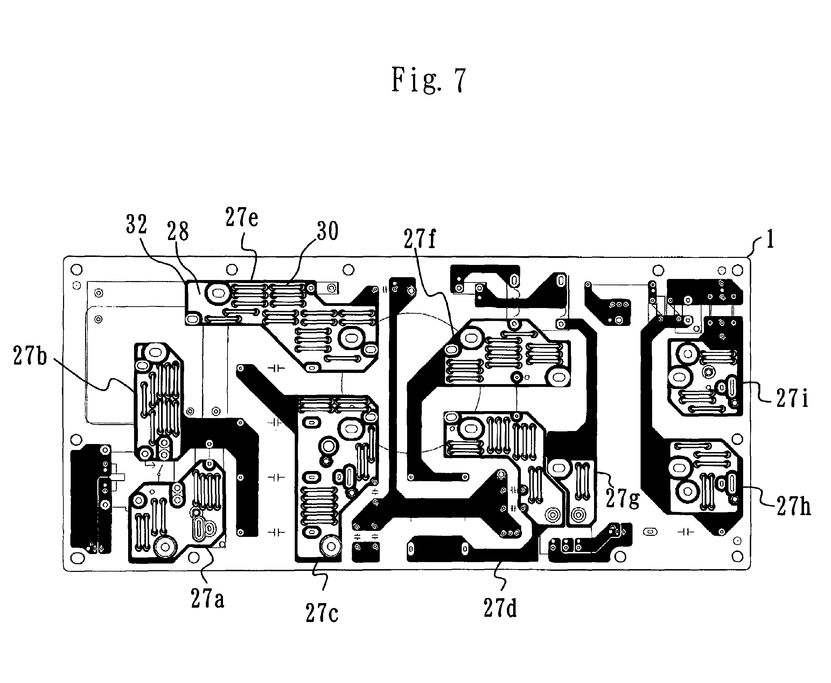

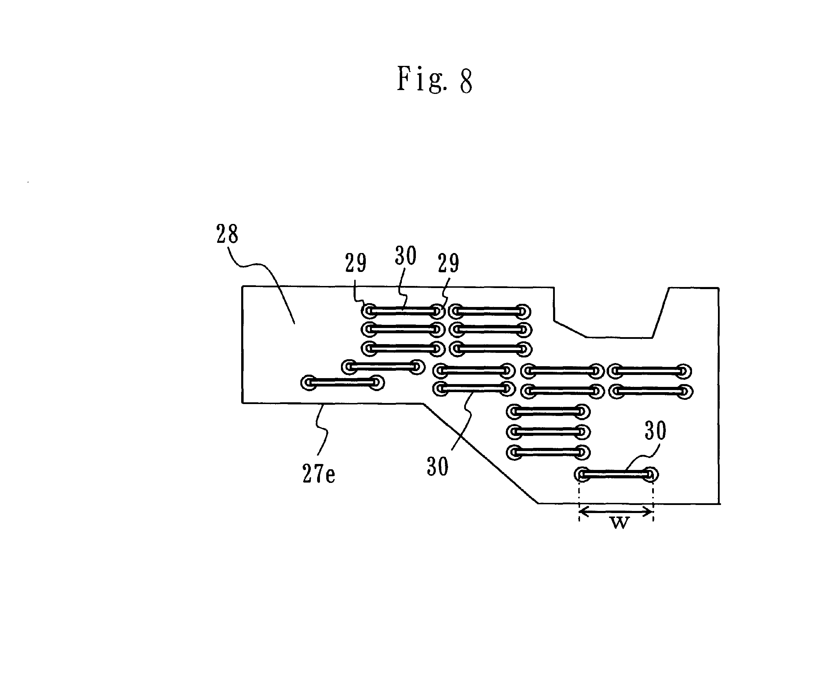

Figs. 7 and 8 show the third embodiment; Fig. 7 shows the soldering surface of the printed circuit board 1, and Fig. 8 is an enlarged view of the soldering surface large current pattern 27e.

In Fig. 7, the soldering surface large current patterns 27a through 27i, which require large current to flow through, are the copper foil flat patterns 28 which expose copper foils.

Through holes 29 are provided on the respective copper foil flat patterns 28 for inserting the jumper lead wires 30, and within the printed circuit board 1, the jumper lead wires 30, of which all width dimensions "w" (Figs. 5 and 8) are almost the same, are soldered by flow soldering.

Further, after forming the resist parts 32 having a certain width (a predetermined width) along the outer circumferences of the respective copper foil flat patterns 28, the jumper lead wires 30 are mounted on the copper foil flat patterns 28 and are soldered by flow soldering.

Fig. 8 is an enlarged view of the soldering surface large current pattern 27e. Fig. 8 only shows the copper foil flat pattern 28 of the soldering surface large current pattern 27e, the through holes 29 formed on the copper foil flat pattern 28, and the jumper lead wires 30 inserted to the through holes 29, omitting the resist part 32, etc.

The printed circuit board 1 of the electronic control device 100 is structured as has been discussed, and thereby it becomes unnecessary to switch the width dimensions "w" of the jumper lead wires 30 on mounting the jumper lead wires 30 to the printed circuit board 1 by an automatic inserting machine, which eliminates a time loss caused by switching the width dimensions "w" of the jumper lead wires 30. Therefore, the productivity of the printed circuit board 1 can be improved.

Embodiment 4.

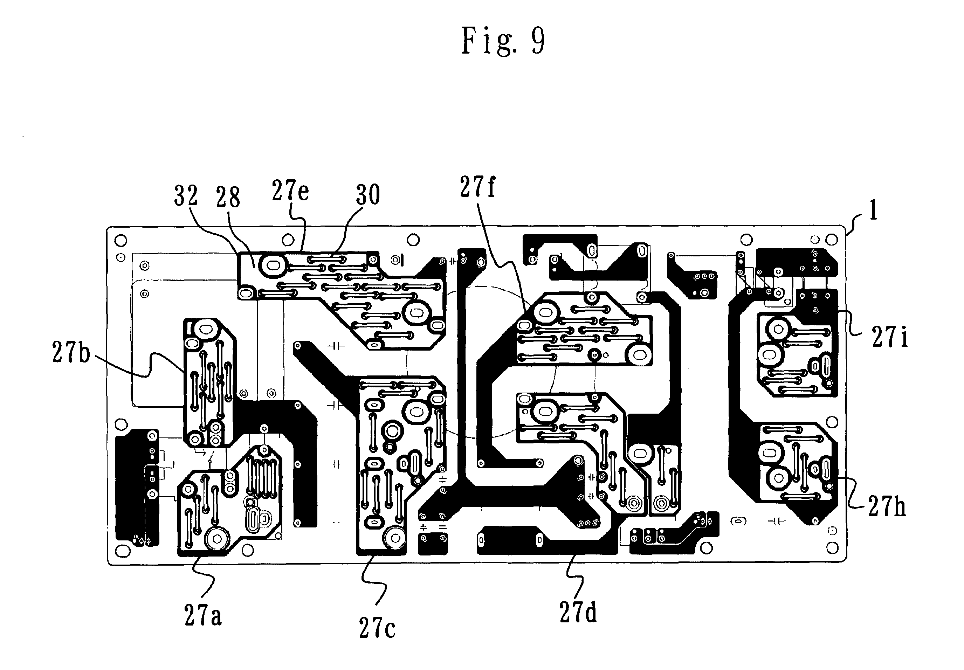

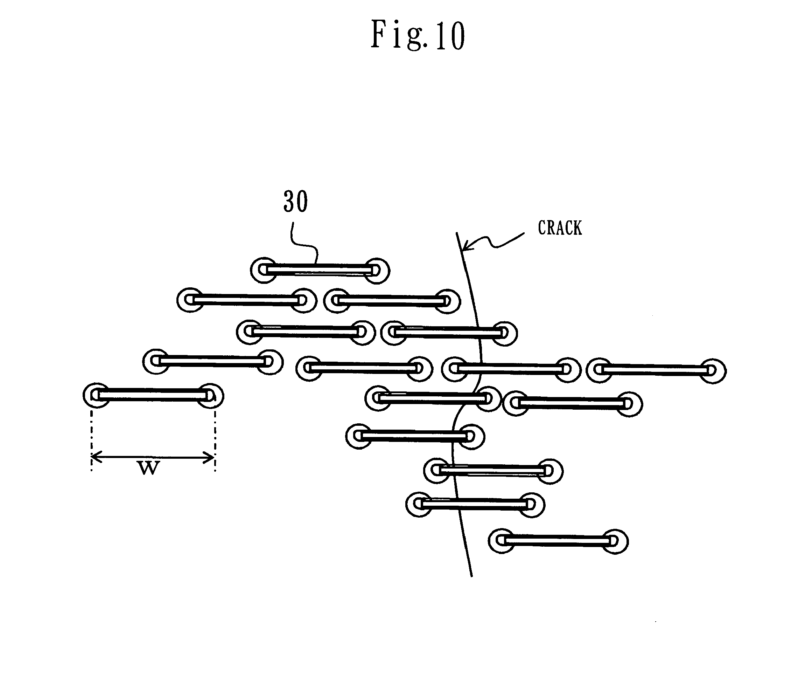

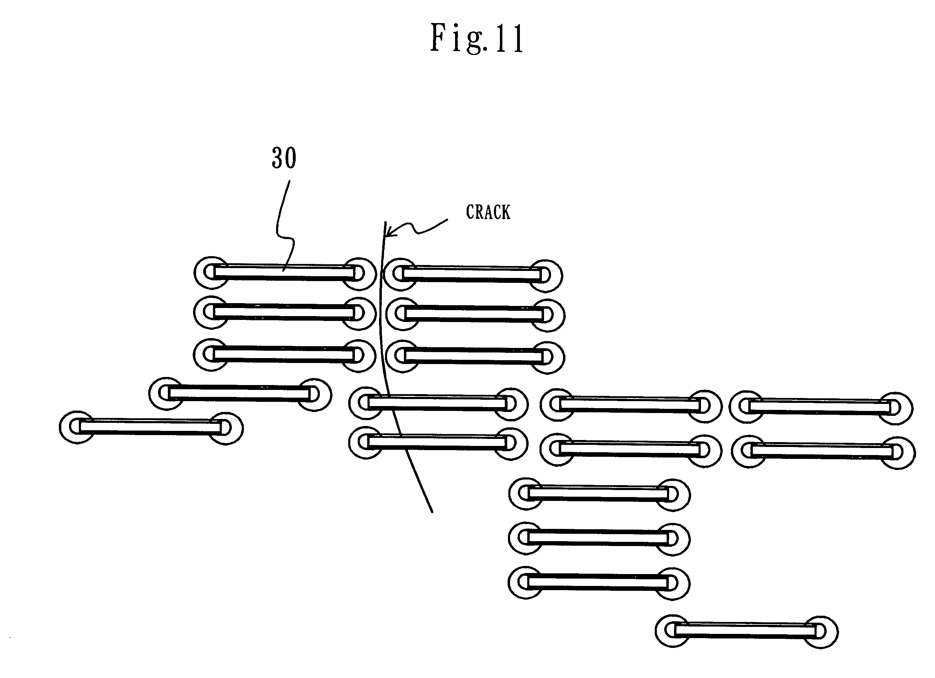

Figs. 9 and 10 show the fourth embodiment; Fig. 9 shows the soldering surface of the printed circuit board 1, and Fig. 10 shows status in which a crack occurs on the copper foil flat pattern 28. Fig. 11 is shown for comparison and shows status in which a crack occurs when the jumper lead wires 30 are not arranged in a zigzag-like shape.

In Fig. 9, the soldering surface large current patterns 27a through 27i, which require large current to flow through, are the copper foil flat patterns 28 which expose copper foil.

Through holes 29 are provided on the respective copper foil flat patterns 28 for inserting the jumper lead wires 30.

Further, after forming the resist parts 32 having a certain width (a predetermined width) along the outer circumferences of the respective copper foil flat patterns 28, the jumper lead wires 30 are mounted on the copper foil flat patterns 28 and are soldered by flow soldering.

In the printed circuit board 1, the jumper lead wires 30, of which all width dimensions "w" (Fig. 10) are almost the same, are mounted so as to be partially overlapping with each other in a zigzag-like shape, and soldered by flow soldering. However, all of the width dimensions "w" do not have to be the same.

The jumper lead wires 30 are mounted on the copper foil flat pattern 28 in a zigzag-like shape and soldered by flow soldering, and thereby even if, for example, a crack as shown in Fig. 10 or disconnection occurs within the copper foil flat pattern 28, the jumper lead wires 30 and the solder 31 (not illustrated) work so as to compensate for the crack or disconnection within the copper foil flat pattern 28.

When the jumper lead wires 30 are not arranged in the zigzag-like shape as shown in Fig. 11, if a crack or disconnection occurs on the copper foil flat pattern 28 between the jumper lead wires 30 located next to each other, the jumper lead wires 30 and the solder 31 (not illustrated) cannot compensate for the crack or disconnection within the copper foil flat pattern 28.

The printed circuit board 1 of the electronic control device 100 is structured as has been discussed, and thereby the jumper lead wires 30 and the solder 31 work so as to compensate for the crack or disconnection within the copper foil flat pattern 28 even if the crack or disconnection occurs within the copper foil flat pattern 28. Therefore, it is possible to secure safety and reliability of the printed circuit board 1.

Embodiment 5.

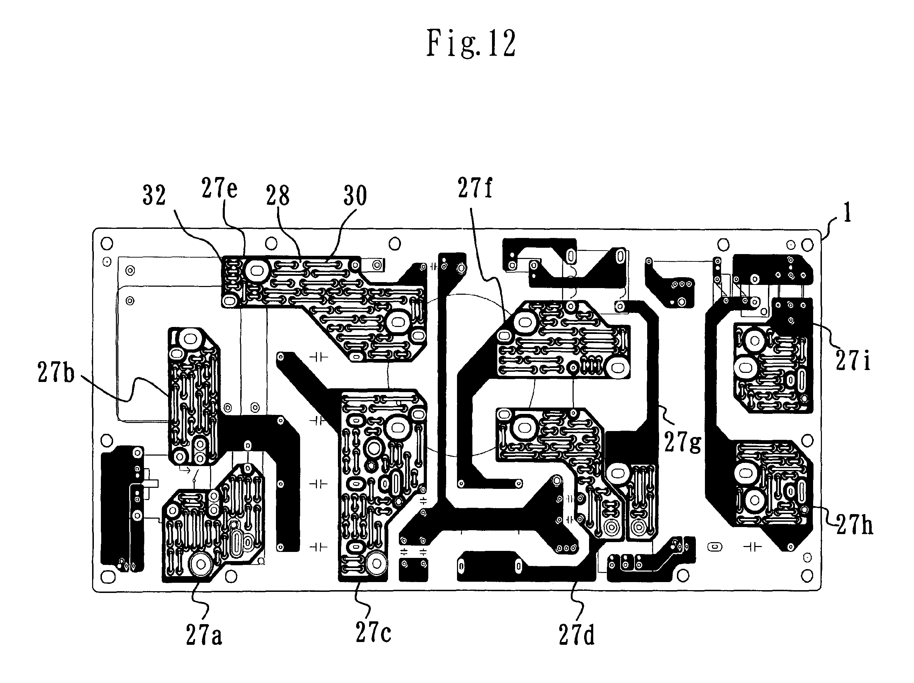

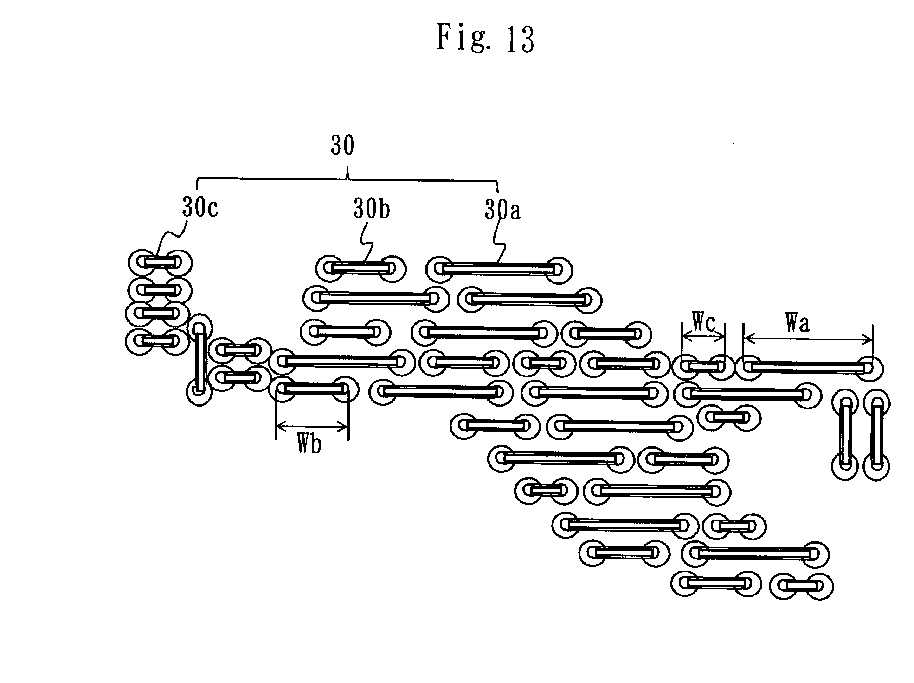

Figs. 12 and 13 show the fifth embodiment; Fig. 12 shows the printed circuit board 1, and Fig. 13 shows the jumper lead wires 30 mounted on the copper foil flat pattern 28 of the soldering surface large current pattern 27e.

In Fig. 12, the soldering surface large current patterns 27a through 27i, which require large current to flow through, are the copper foil flat patterns 28 which expose copper foil.

Through holes 29 are provided on the copper foil flat patterns 28 for inserting the jumper lead wires 30.

Further, after forming the resist parts 32 having a certain width along the outer circumferences of the respective copper foil flat patterns 28, the jumper lead wires 30 are mounted on the copper foil flat patterns 28 and are soldered by flow soldering.

In the printed circuit board 1, plural jumper lead wires 30 having different width dimensions are combined.

For example, as shown in Fig. 13, three types of jumper lead wires 30a, 30b, and 30c are combined for the jumper lead wires 30. If it is assumed that the width dimensions of the three types of jumper lead wires 30a, 30b, and 30c are Wa, Wb, and Wc, the following relationship is satisfied by Wa, Wb, and Wc:

$$Wa > Wb > Wc \qquad (1)$$

Further, as for the mounting direction at flow soldering, the three types of jumper lead wires 30a, 30b, and 30c are mounted horizontally and also vertically with respect to the carrying direction of the printed circuit board 1, and soldered by flow soldering.

Here, the type and the arrangement of the jumper lead wires 30 can be arbitrary.

The printed circuit board 1 is structured as has been discussed, and thereby the mounting density of the jumper lead wires 30 on the copper foil flat pattern 28 becomes larger than the printed circuit board 1 in the first through fourth embodiments, which increases the volume of the conductor part of the copper foil flat pattern 28. Therefore, it is possible to further improve the radiation performance and increase the current allowable value.

Embodiment 6.

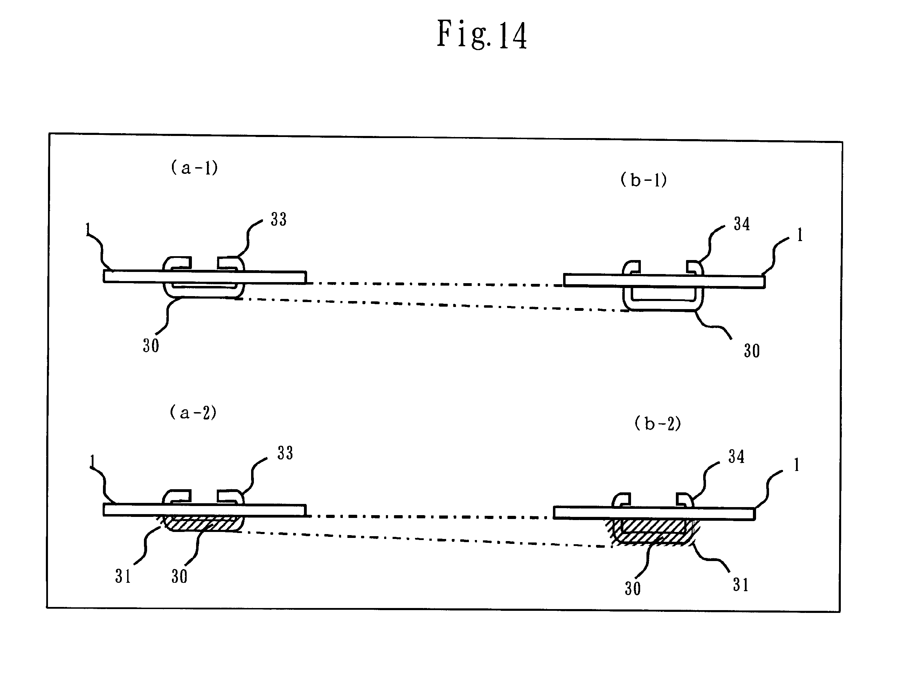

Fig. 14 shows the sixth embodiment, and is a side view of a clinch shape of the jumper lead wire 30 of the printed circuit board 1 ((a-1) is a side view of general clinch shape of the jumper lead wire 30 (before flow soldering); (a-2) is a side view of the general clinch shape of the jumper lead wire 30 (after flow soldering); (b-1) is a side view of a clinch shape of the jumper lead wire 30 when the clinching tension is weakened (before flow soldering); and (b-2) is a side view of the clinch shape of the jumper lead wire 30 when the clinching tension is weakened (after flow soldering)).

In Fig. 14, on clinch mounting the jumper lead wire 30 by the automatic inserting machine from the flow soldering surface side of the printed circuit board 1, with respect to the general clinch mounting shape 33 ((a-1) and (a-2) in Fig. 14), the tension of clinching (clinching force) is made less than the normal tension, so that the clinch mounting shape becomes such as, for example, the clinch mounting shape 34 ((b-1) and (b-2) in Fig. 14).

The clinch mounting shape of the jumper lead wire 30 is made to be the clinch mounting shape 34 as shown in (b-1) and (b-2) in Fig. 14, and thereby the distance between the surface of the copper foil flat pattern 28 and the jumper lead wire 30 of the flow soldering part of the printed circuit board 1 can be made larger than the general clinch mounting shape 33 ((a-1) and (a-2) in Fig. 14).

As has been discussed, on clinch mounting the jumper lead wires 30 by the automatic inserting machine, the tension of clinching (clinching force) is weakened than the normal tension; that is, the clinch shape is made to be, for example, the clinch mounting shape 34, and thereby more solder 31 is adhered to an extended space (a space of a predetermined size) between the surface of the copper foil flat pattern 28 and the jumper lead wire 30 of the flow soldering part of the printed circuit board 1 at flow soldering. Therefore, it is possible to further improve the radiation performance and increase the current allowable value compared with the general clinch mounting shape 33.

Embodiment 7.

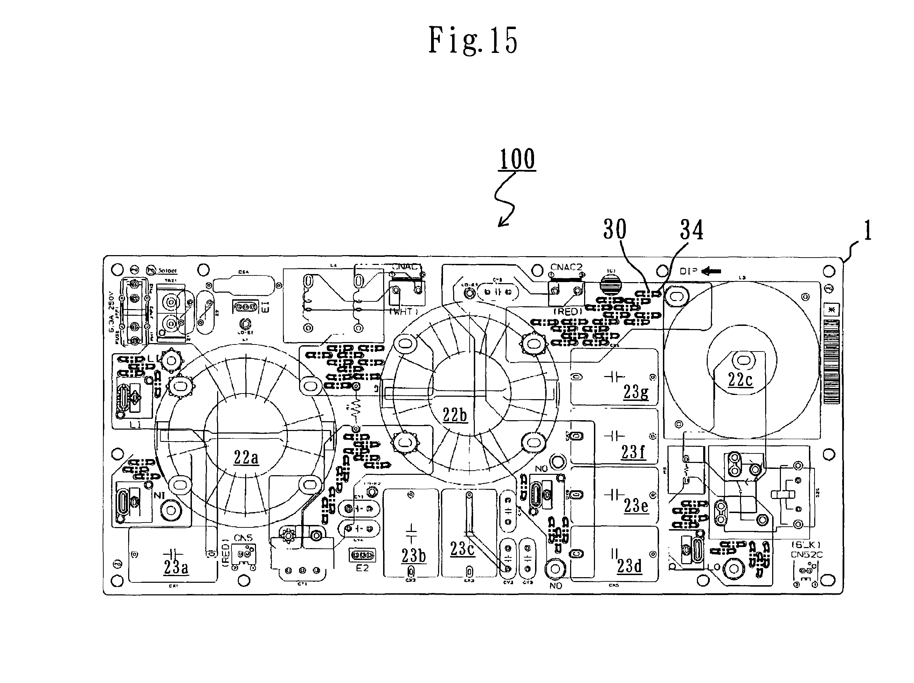

Fig. 15 shows the seventh embodiment, and is a pattern diagram showing a side of a surface to which the component with lead is mounted (component surface) of the printed circuit board 1 of the electronic control device 100.

In Fig. 15, the electric component with lead is arranged at a position so as not to contact the clinch mounting shape 34 of the jumper lead wire 30 mounted from the flow soldering surface and soldered by flow soldering.

The electric component with lead is, for example, the noise-filtering coils 22a through 22c, the noise-filtering capacitors 23a through 23g, etc.

The printed circuit board 1 is structured as has been discussed, and thereby the clinch mounting shape 34 of the jumper lead wire 30 mounted from the flow soldering surface, which is a charging part, is not contacted with the electric component with lead. Therefore, it is possible to secure safety of the electric component with lead.

Here, generally, soldering material, of which fusing point is low, of which melted solder has appropriate fluidity, viscosity, surface tension, and suitable wettability with base material, and further which satisfies requirements of mechanical strength and conductivity of the soldered bonded part, is used. It is preferable to use lead-free soldering for the solder used for the flow soldering in the present embodiment. However, tin-lead eutectic solder can be also used.

Having thus described several particular embodiments of the present invention, various alterations, modifications, and improvements will readily occur to those skilled in the art. Such alterations, modifications, and improvements are intended to be part of this disclosure, and are intended to be within the spirit and scope of the present invention. Accordingly, the foregoing description is by way of example only, and is not intended to be limiting. The present invention is limited only as defined in the following claims and the equivalents thereto.

**Claims**

1. An electronic control device (100), in which a current circuit is formed on a printed circuit board (1), and an electric component with lead is soldered to the printed circuit board by a flow soldering method, the electronic control device comprising:

   a copper foil flat pattern (28) forming a soldering surface current pattern which is flowed through by current of the current circuit at a soldering surface of the printed circuit board to be soldered by flow soldering, and exposing copper foil;
   a through hole (29) formed on the copper foil flat pattern; and
   a jumper lead wire (30) to be mounted on the through hole from the soldering surface side and soldered by the flow soldering method.

2. The electronic control device according to claim 1, wherein the soldering surface current pattern to which the jumper lead wire is soldered is a soldering surface large current pattern (27a, 27b, 27c, 27d, 27e, 27g, 27h, 27i) which is flowed through by current of equal to or greater than 20 A.

3. The electronic control device according to claim 1, wherein the soldering surface current pattern to which the jumper lead wire is soldered is a soldering surface large current pattern (27a, 27b, 27c, 27d, 27e, 27g, 27h, 27i) which is flowed through by current driving a compressor (6) of an air conditioner.

4. The electronic control device according to one of claims 1 through 3, wherein along an outer circumference of the copper foil flat pattern, a resist part having a predetermined width is formed.

5. The electronic control device according to one of claims 1 through 4, wherein the jumper lead wire has a width of almost same dimension.

6. The electronic control device according to one of claims 1 through 4, wherein the jumper lead wire is mounted on the copper foil flat pattern in a zigzag-like shape.

7. The electronic control device according to one of claims 1 through 4, wherein a plurality of the jumper lead wires of which width dimensions are different are combined and mounted on the copper foil flat pattern.

8. The electronic control device according to one of claims 1 through 7, wherein on clinch mounting the jumper lead wire from the soldering surface of the printed circuit board, a clinching force is weakened so as to form a space of a predetermined size between the copper foil flat pattern and the jumper lead wire.

9. The electronic control device according to one of claims 1 through 8, wherein the electric component with lead to be mounted on a component surface of the printed circuit board is arranged not to contact the jumper lead wire.

10. The electronic control device according to one of claims 1 through 9, wherein lead-free soldering is used for the flow soldering.

Fig. 1

Fig. 2

EP 2 209 355 A1

Fig. 3

# Fig. 4

(a)

(b)

(c)

EP 2 209 355 A1

# Fig. 5

Fig. 6

(a)

27g

30

28

30

B

27d

(b)

1

30

(c)

30

1

31

29
28

32

EP 2 209 355 A1

Fig. 7

EP 2 209 355 A1

EP 2 209 355 A1

Fig. 8

# Fig. 9

EP 2 209 355 A1

Fig.10

Fig.11

CRACK

30

# Fig.12

# Fig. 13

# Fig.14

(a-1)

1   33

30

(b-1)

34   1

30

(a-2)

1   33

31   30

(b-2)

34   1

30   31

EP 2 209 355 A1

Fig.15

Europäisches
Patentamt

European
Patent Office

Office européen
des brevets

**EUROPEAN SEARCH REPORT**

Application Number

EP 09 00 9936

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | JP 10 200221 A (TOSHIBA CORP; TOSHIBA AVE KK) 31 July 1998 (1998-07-31)<br>* abstract * | 1,4,5,8, 10<br>2 | INV.<br>H05K1/02<br>H05K3/22<br>H05K3/34 |
| X | JP 61 263193 A (MATSUSHITA ELECTRIC IND CO LTD) 21 November 1986 (1986-11-21)<br>* the whole document * | 1,5,8 | |
| Y<br>A | EP 0 375 428 A1 (TEXAS INSTRUMENTS INC [US]) 27 June 1990 (1990-06-27)<br>* page 2, column 1, line 4 - line 13 *<br>* page 3, column 3, line 9 - line 40; figures * | 2<br>1,7-10 | |
| A | DE 44 25 803 A1 (SIEMENS AG OESTERREICH [AT]) 16 February 1995 (1995-02-16)<br>* column 2, line 8 - column 3, line 45; figures * | 1,5,7-10 | |
| A | WO 97/15097 A1 (WITMETAAL B V [NL]; GODIJN PAUL WILLEM [NL]; OUD MARTINUS ADRIANUS [NL] 24 April 1997 (1997-04-24)<br>* page 3, line 22 - page 5, line 25; figures * | 1,5,7-10 | TECHNICAL FIELDS SEARCHED (IPC)<br><br>H05K |
| A | EP 0 126 164 A1 (MATSUSHITA ELECTRIC IND CO LTD [JP]) 28 November 1984 (1984-11-28)<br>* page 4, line 17 - page 7, line 14; figures * | 1,5,7-10 | |

The present search report has been drawn up for all claims

| Place of search | Date of completion of the search | Examiner |
|---|---|---|
| The Hague | 8 April 2010 | Geoghegan, C |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 09 00 9936

This annex lists the patent family members relating to the patent documents cited in the above-mentioned European search report.
The members are as contained in the European Patent Office EDP file on
The European Patent Office is in no way liable for these particulars which are merely given for the purpose of information.

08-04-2010

| Patent document cited in search report | | Publication date | Patent family member(s) | | Publication date |
|---|---|---|---|---|---|
| JP 10200221 | A | 31-07-1998 | CN 1187751 A<br>JP 3515868 B2<br>TW 388186 B | | 15-07-1998<br>05-04-2004<br>21-04-2000 |
| JP 61263193 | A | 21-11-1986 | JP 1840918 C<br>JP 2017954 B | | 25-04-1994<br>24-04-1990 |
| EP 0375428 | A1 | 27-06-1990 | DE 68915259 D1<br>DE 68915259 T2<br>JP 2224389 A<br>JP 2858834 B2<br>US 4967042 A | | 16-06-1994<br>25-08-1994<br>06-09-1990<br>17-02-1999<br>30-10-1990 |
| DE 4425803 | A1 | 16-02-1995 | NONE | | |
| WO 9715097 | A1 | 24-04-1997 | AU 7229596 A<br>DE 69607652 D1<br>DE 69607652 T2<br>EP 0876691 A1<br>JP 11513845 T<br>NL 1001453 C2 | | 07-05-1997<br>11-05-2000<br>19-10-2000<br>11-11-1998<br>24-11-1999<br>22-04-1997 |
| EP 0126164 | A1 | 28-11-1984 | DE 3379531 D1<br>WO 8402248 A1<br>JP 59098591 A<br>US 4592137 A | | 03-05-1989<br>07-06-1984<br>06-06-1984<br>03-06-1986 |

EPO FORM P0459

For more details about this annex : see Official Journal of the European Patent Office, No. 12/82

**REFERENCES CITED IN THE DESCRIPTION**

**Patent documents cited in the description**

- JP 2008016582 A